# EUROPEAN PATENT APPLICATION

(11) **EP 1 127 899 A1**
(43) Date of publication of application: **29.08.2001**
(21) Application number: 01301582.1
(22) Date of filing: 22.02.2001
(51) Int. Cl.: C08F 32/08, G03F 7/039, G03F 7/004

(54) **Polymer and photoresist compositions**

(30) Priority: 25.02.2000 US 184845 P
(71) Applicant: Shipley Company LLC, Marlborough, MA 01752 (US)
(72) Inventor: Barclay, George G., Jefferson, Massachusetts 01522 (US); Zampini, Anthony, Westborough, Massachusetts 01581 (US)
(74) Representative: Kent, Venetia Katherine

(57) **Abstract**

Disclosed are polymers containing as polymerized units one or more cyclic olefin monomers having one or more pendant cyclic electron withdrawing groups, methods of preparing such polymers, photoresist compositions including such polymers as resin binders and methods of forming relief images using such photoresist compositions.

## Description

### Background of the Invention

This invention relates generally to polymer compositions useful in photoresist compositions. In particular, this invention relates to polymer compositions including cyclic olefin monomers useful as binders in photoresist compositions.

Photoresists are photosensitive films used for transfer of images to a substrate. A coating layer of a photoresist is formed on a substrate and the photoresist layer is then exposed through a photomask to a source of activating radiation. The photomask has areas that are opaque to activating radiation and other areas that are transparent to activating radiation. Exposure to activating radiation provides a photoinduced chemical transformation of the photoresist coating to thereby transfer the pattern of the photomask to the photoresist-coated substrate. Following exposure, the photoresist is developed to provide a relief image that permits selective processing of a substrate.

A photoresist can be either positive-acting or negative-acting. For most negative-acting photoresists, those coating layer portions that are exposed to activating radiation polymerize or crosslink in a reaction between a photoactive compound and polymerizable agents of the photoresist composition. Consequently, the exposed coating portions are rendered less soluble in a developer solution than unexposed portions. For positive-acting photoresists, exposed portions are rendered more soluble in a developer solution while areas not exposed remain comparatively less developer soluble. In general, photoresist compositions include at least a resin binder component and a photoactive agent.

More recently, chemically-amplified type resists have been increasingly employed, particularly for formation of sub-micron images and other high performance applications. Such photoresists may be negative-acting or positive-acting and generally include many crosslinking events (in the case of a negative-acting resist) or deprotection reactions (in the case of a positive-acting resist) per unit of photogenerated acid. In the case of positive chemically-amplified resists, certain cationic photoinitiators have been used to induce cleavage of certain "blocking" groups pendant from a photoresist binder, or cleavage of certain groups comprising a photoresist binder backbone. See, for example, US Patent Nos. 5,075,199; 4,968,581; 4,810,613; and 4,491,628 and Canadian Patent Application 2,001,384. Upon cleavage of the blocking group through exposure of a coating layer of such a resist, a polar functional group is formed, e.g. carboxyl or imide, which results in different solubility characteristics in exposed and unexposed areas of the resist coating layer. See also R.D. Allen et al. Proceedings of SPIE, 2724:334-343 (1996); and P. Trefonas et al. Proceedings of the 11^{th} International Conference on Photopolymers (Soc. of Plastics Engineers), pp 44-58 (October 6, 1997).

While currently available photoresists are suitable for many applications, current resists can also exhibit significant shortcomings, particularly in high performance applications such as formation of highly resolved sub-half micron and sub-quarter micron features.

Consequently, interest has increased in photoresists that can be photoimaged with short wavelength radiation, including exposure radiation of about 250 nm or less, or even about 200 nm or less, such as wavelengths of about 248 nm (provided by a KrF laser) or 193 nm (provided by an ArF exposure tool). Use of such short exposure wavelengths can enable formation of smaller features. Accordingly, a photoresist that yields well-resolved images upon 248 or 193 nm exposure could enable formation of extremely small (e.g. sub-quarter micron) features that respond to constant industry demands for smaller dimension circuit patterns, e.g. to provide greater circuit density and enhanced device performance.

However, many current photoresists are generally designed for imaging at relatively higher wavelengths, such as I-line (365 nm) and G-line (436 nm) exposures, and are generally unsuitable for imaging at short wavelengths, such as 248 nm and 193 nm. In particular, prior resists exhibit poor resolution (if any image at all can be developed) upon exposure to these shorter wavelengths. Among other things, current photoresists can be highly opaque to extremely short exposure wavelengths, such as 248 nm and 193 nm, thereby resulting in poorly resolved images. Efforts to enhance transparency for short wavelength exposure can negatively impact other important performance properties such as substrate adhesion or swelling, which in turn can dramatically compromise image resolution.

Cyclic monomer units, particularly those containing functional groups, impart various properties to the resin binder when incorporated into the backbone of the resin binder. One advantage of such cyclic monomers is their transparency. Anhydrides incorporated into the resin binder backbone help reduce swelling. For example, Barclay et al., *The Effect of Polymer Architecture on the Aqueous Base development of Photoresists,* Polym. Prepr. (American Chemical Society, Division of Polymer Chemistry), volume 40(1), pages 438-439, 1999, discloses the incorporation of itaconic anhydride into a photoresist resin binder, such as a (meth)acrylic polymer. However, such anhydrides can undergo hydrolysis in the presence of alcohols or other solvents, especially solvents that are contaminated with small amounts of water.

Such swelling of resin binders could be even further reduced or eliminated through the use of a binder containing a high proportion of cyclic olefin monomers in the polymer backbone, particularly cyclic olefin monomers containing functional groups. One approach for achieving this is to use only cyclic olefin monomers in the preparation of the polymer. However, this approach suffers from the difficulty in polymerizing such cyclic monomers, especially when the cyclic monomers contain electron withdrawing groups, such as anhydrides. In particular, 5-norbornene-2,3-dicarboxylic anhydride cannot be easily polymerized.

For example, WO 99/42510 discloses resins useful in photoresist compositions wherein the resin is composed of norbornenyl monomers containing various functional groups. This patent application is directed to a method for preparing a polycyclic polymer and introducing difficult to polymerize functionalities into the polymer by post-polymerization functionalization. Such post polymerization treatment avoids the use of monomers containing such difficult to polymerize functionalities as nitrogen containing groups, such as amides, and hydroxyl containing groups, such as alcohols and carboxylic acids. The post polymerization functionalization is achieved by using cyclic monomers containing protected functionalities, deprotecting the functionality to give a free functionality and then reacting the free functionality to give a post-functionalized moiety. Drawbacks of this invention are that a number of extra steps are required which greatly adds to the time and cost of the preparation.

It is thus desirable to have photoresist compositions that can be imaged at short wavelengths, contain resin binders having reduced swelling and have better substrate adhesion than known photoresist compositions. It is further desirable to have photoresist compositions containing resin binders that can be prepared with few reactions or transformations.

### Summary of the Invention

It has been surprisingly found that polymers containing as polymerized units cyclic olefin monomers having pendant cyclic electron withdrawing groups can be readily obtained without the use of ring-opening polymerizations. It has also been surprisingly found that resin binders can be prepared having a high proportion of cyclic olefin monomers in the polymer backbone, including cyclic monomers having pendant cyclic electron withdrawing groups.

In one aspect, the present invention provides a polymer including as polymerized units one or more cyclic olefin monomers of the formula 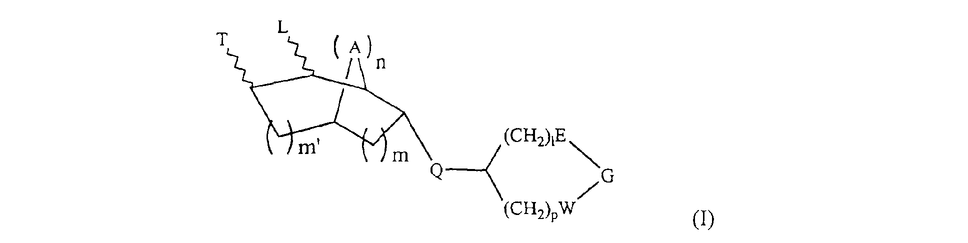 wherein A = O, S, CH₂, and NR¹; R¹ = phenyl, substituted phenyl, benzyl, substituted benzyl, (C₁-C₈)alkyl and substituted (C₁-C₈)alkyl; G = C(Z'), O, S, and NR²; R² = (C₁-C₈)alkyl and substituted (C₁-C₈)alkyl; E and W are independently selected from C(Z'), O, NR² and a chemical bond; Z' = O or S; Q is a chemical bond or a linking group; n = 0 to 3; m = 0 to 2; m' = 0 to 2; 1 = 0 to 5; and p = 0 to 5; provided that 1 + p = 3 to 5; provided that when A = O, S or NR¹, n = 1; wherein T and L are taken together and selected from a double bond or a 5 to 8-membered unsaturated ring; and optionally one or more ethylenically or acetylenically unsaturated monomers.

In a second aspect, the present invention provides a method of polymerizing one or more cyclic olefin monomers of the formula 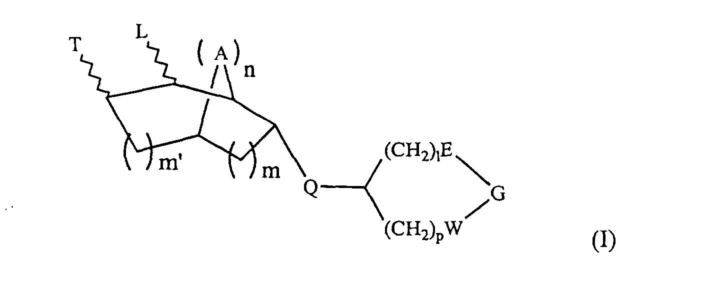 wherein A = O, S, CH₂, and NR¹; R¹ = phenyl, substituted phenyl, benzyl, substituted benzyl, (C₁-C₈)alkyl and substituted (C₁-C₈)alkyl; G = C(Z'), O, S, and NR²; R² = (C₁-C₈)alkyl and substituted (C₁-C₈)alkyl; E and W are independently selected from C(Z'), O, NR² and a chemical bond; Z' = O or S; Q is a chemical bond or a linking group; n = 0 to 3; m = 0 to 2; m' = 0 to 2; 1 = 0 to 5; and p = 0 to 5; provided that 1 + p = 3 to 5; provided that when A = O, S or NR¹, n = 1; wherein T and L are taken together and selected from a double bond or a 5 to 8-membered unsaturated ring; including the step of contacting the one or more cyclic olefin monomers with one or more catalysts selected from palladium(II) polymerization catalyst, nickel(II) polymerization catalyst and free radical polymerization catalyst.

In a third aspect, the present invention provides a photoresist composition including one or more polymers as described above and a photoactive component.

In a fourth aspect, the present invention provides a method for forming a photoresist relief image, including the steps of applying a coating layer of the photoresist composition described above; exposing the photoresist coating layer to patterned activating radiation; developing the exposed photoresist coating layer to provide a photoresist relief image.

### Detailed Description of the Invention

The terms "resin" and "polymer" are used interchangeably throughout this specification. The term "alkyl" refers to linear, branched, cyclic and spiro alkyl. The terms "halogen" and "halo" include fluorine, chlorine, bromine, and iodine. Thus the term "halogenated" refers to fluorinated, chlorinated, brominated, and iodinated. "Polymers" refer to both homopolymers and copolymers. The term "(meth)acrylate" refers to both acrylate and methacrylate. Likewise, the term "(meth)acrylic" refers to both acrylic and methacrylic.

All amounts are percent by weight and all ratios are by weight, unless otherwise noted. All numerical ranges are inclusive.

The present invention provides a polymer including as polymerized units one or more cyclic olefin monomers having one or more pendant electron withdrawing groups. The term "pendant cyclic electron withdrawing group" refers to a cyclic electron drawing group that depends from a cyclic olefin. By "cyclic olefin" is meant any cyclic compound having a double bond within the ring. "Cyclic olefin monomer" refers to any cyclic olefin capable of being polymerized.

The polymers of the present invention contain from 1 to 100 percent by weight, based on the total weight of the monomers, of one or more cyclic olefin monomers having one or more pendant cyclic electron withdrawing groups. Thus the polymers of the present invention may be homopolymers or copolymers of such cyclic olefin monomers. It will be appreciated by those skilled in the art that any ethylenically unsaturated monomer, acetylenically unsaturated monomer or mixtures thereof may be copolymerized with the cyclic olefin monomers of the present invention. Such ethylenically or acetylenically unsaturated monomer or mixtures thereof may be present in the polymers of the present invention in an amount in the range of 1 to 99 percent by weight, based on the total weight of the monomers.

Any cyclic olefin monomer having one or more pendant cyclic electron withdrawing group is useful in the polymers of the present invention. It is preferred that the cyclic olefin monomer is a 5- to 7-membered ring. Suitable cyclic olefin monomers having one or more pendant cyclic electron withdrawing groups useful in the present invention include those of Formula I 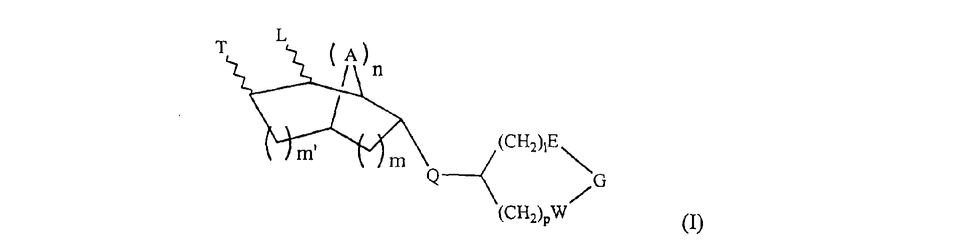 wherein A = O, S, CH₂, and NR¹; R¹ = phenyl, substituted phenyl, benzyl, substituted benzyl, (C₁-C₈)alkyl and substituted (C₁-C₈)alkyl; G = C(Z'), O, S, and NR²; R² = (C₁-C₈)alkyl and substituted (C₁-C₈)alkyl; E and W are independently selected from C(Z'), O, NR² and a chemical bond; Z' = O or S; Q is a chemical bond or a linking group; n = 0 to 3; m = 0 to 2; m' = 0 to 2; 1 = 0 to 5; and p = 0 to 5; provided that 1 + p = 3 to 5; provided that when A = O, S or NR¹, n = 1; wherein T and L are taken together and selected from a double bond or a 5 to 8-membered unsaturated ring. It will be appreciated by those skilled in the art that when n = 0, the cyclic olefin monomer is not bridged. No particular stereochemistry is intended by Figure I, thus cyclic olefin monomers having Q in the endo or exo position are contemplated by the present invention.

Q may be any suitable linking group having from 1 to 12 carbon atoms wherein one or more of the carbon atoms may be independently placed by a functional group selected from ester, thioester, ether, ketone, sulfate, sulfonamide, amide, amine, sulfone, glycol ether or silyl. Suitable linking groups include, but are not limited to, alkyl, substituted alkyl, aryl, substituted aryl, heteroaryl, substituted heteroaryl, aralkyl, and substituted aralkyl.

The term "aryl" refers to any aromatic ring system having 12 carbons or less such as phenyl, substituted phenyl, biphenyl, substituted biphenyl, naphthyl and substituted naphthyl. The term "heteroaryl" refers to any aromatic ring system having 12 carbons or less and at least one heteroatom such as oxygen, sulfur or nitrogen. By "substituted alkyl" is meant any alkyl having one or more of its hydrogens replaced by another substituent group, such as halo, hydroxy, cyano, mercapto, and the like.

Suitable cyclic monomers of the present invention wherein T and L are joined to form a 5 to 8-membered unsaturated ring include those having the Formula Ia 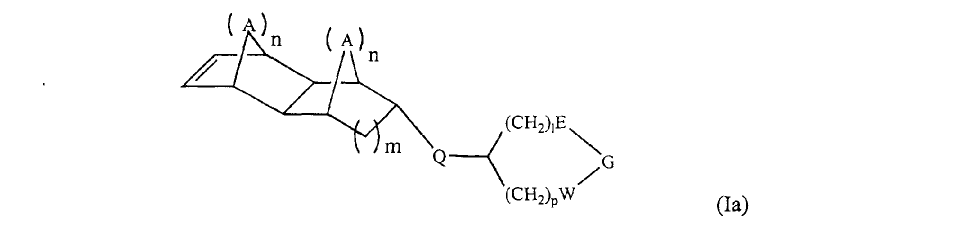 wherein A, E, W, G, Q, l, m, n and p are as defined above.

It is preferred that the cyclic olefin monomers of the present invention have the structure of Formula Ib 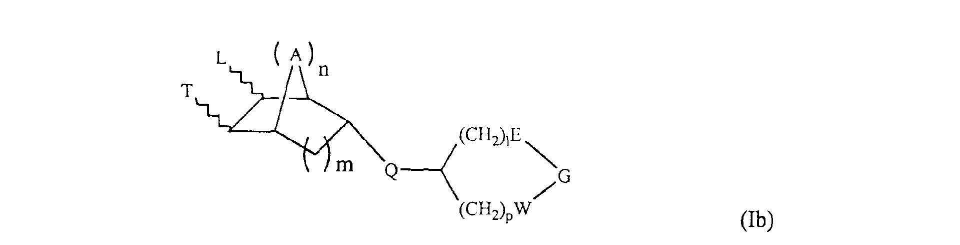 wherein A, E, W, G, Q, l, m, n and p are as defined above. More preferably, the cyclic olefin monomers have the structure of Formula Ic 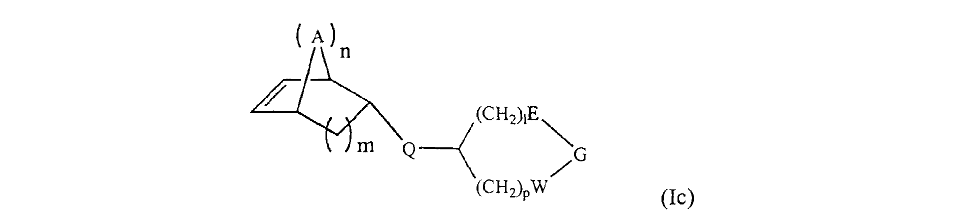 wherein A, E, W, G, Q, l, m, n and p are as defined above. It is further preferred that n is 1 or 2. It is still further preferred that A is CH₂. It is also preferred that m is 0 or 1.

By "substituted phenyl," "substituted biphenyl" and "substituted naphthyl" is meant a phenyl, biphenyl or naphthyl ring having one or more of its hydrogens replaced with another substituent group. By "substituted benzyl" or "substituted aralkyl" is meant a benzyl or aralkyl group having one or more of its hydrogens replaced with another substituent group. Suitable substituent groups include, but are not limited to, cyano, halo, (C₁-C₄)alkoxy, (C₁-C₄)alkyl, amino, (C₁-C₄)alkylamino, (C₁-C₄)dialkylamino, (C₁-C₄)alkylthio, and the like.

The cyclic olefin monomers useful in the present invention may be optionally substituted. By substituted is meant that one or more of the hydrogens on the ring carbons is replaced by one or more substituent groups. Suitable substituent groups include (C₁-C₁₂)alkyl, phenyl, substituted phenyl, (C₁-C₁₂)alkoxy, (C₇-C₁₀)alkaryl, (C₁-C₈)perhaloalkyl, and halogen. Preferred substituents are (C₁-C₁₂)alkyl, more preferably (C₁-C₄)alkyl, and most preferably (C₁-C₂)alkyl.

Preferred cyclic olefin monomers are those containing as pendant cyclic electron withdrawing groups carbonyl, thiocarbonyl, oxa, mercapto, amino, substituted amino, amido, and the like as ring atoms. Suitable electron withdrawing groups include, but are not limited to anhydrides, thioanhydrides, lactones, thiolactones, imides, thioimides, lactams and thiolactams. It is preferred that the electron withdrawing groups are anhydrides, lactones, imides and lactams, and more preferably anhydrides and lactones.

Suitable cyclic olefin monomers of the present invention include, but are not limited to, those containing as the cyclic olefin moiety norbornenyl monomers, cyclohexenyl monomers, cyclopentenyl monomers, cyclopentadienyl monomers, dicyclopentenyl monomers, dicyclopentadienyl monomers and mixtures thereof. Suitable norbornenyl monomers having pendant electron withdrawing groups include those of Formula II 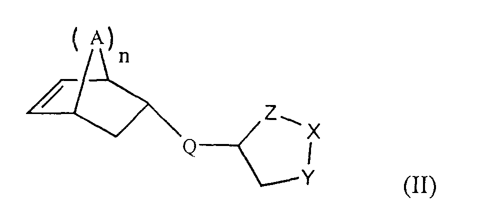 wherein A, Q and n are as defined above, Z = CR⁷R⁸, C(O), C(S), O or S; X and Y are independently selected from CH₂, C(O), C(S), O or NR²; and R² = (C₁-C₈)alkyl and substituted (C₁-C₈)alkyl; R⁷ and R⁸ are independently selected from H, (C₁-C₆)alkyl, and substuituted (C₁-C₆)alkyl; provided that at least one of X, Y and Z is selected from C(O) or C(S); and wherein the cyclic olefin monomer is optionally substituted. Preferred cyclic norbornenyl olefin monomers of Formula II are those wherein Z is C(O), and more preferably wherein Z is C(O), X is oxygen and Y is CH₂.

The cyclic olefinic monomers having pendant cyclic electron withdrawing groups may be prepared by methods known in the art.

The ethylenically or acetylenically unsaturated monomers that may be used in the present invention are any that will copolymerize with the cyclic olefinic monomers having one or more pendant electron withdrawing groups of the present invention. It will be appreciated by those skilled in the art that one or more ethylenically or acetylenically unsaturated monomers may be copolymerized with the cyclic olefinic monomers of the present invention. The total amount of the ethylenically and acetylenically monomers useful in the polymer of the present invention is from 1 to 99 percent by weight, based on the total weight of the monomers, preferably from 10 to 95 percent by weight, more preferably from 20 to 90 percent by weight, and even more preferably from 60 to 90 percent by weight.

Suitable ethylenically or acetylenically unsaturated monomers include, but are not limited to: (meth)acrylic acid, (meth)acrylamides, alkyl (meth)acrylates, alkenyl (meth)acrylates, aromatic (meth)acrylates, vinyl aromatic monomers, nitrogen-containing compounds and their thio-analogs such as their sulfur-oxide analogs, substituted ethylene monomers, unsubstituted cyclic olefins, substituted cyclic olefins, and the like.

Typically, the alkyl (meth)acrylates useful in the present invention are (C₁-C₂₄)alkyl (meth)acrylates. Suitable alkyl (meth)acrylates include, but are not limited to, "low cut" alkyl (meth)acrylates, "mid cut" alkyl (meth)acrylates and "high cut" alkyl (meth)acrylates.

"Low cut" alkyl (meth)acrylates are typically those where the alkyl group contains from 1 to 6 carbon atoms. Suitable low cut alkyl (meth)acrylates include, but are not limited to: methyl methacrylate ("MMA"), methyl acrylate, ethyl acrylate, propyl methacrylate, butyl methacrylate ("BMA"), butyl acrylate ("BA"), isobutyl methacrylate ("IBMA"), hexyl methacrylate, cyclohexyl methacrylate, cyclohexyl acrylate and mixtures thereof.

"Mid cut" alkyl (meth)acrylates are typically those where the alkyl group contains from 7 to 15 carbon atoms. Suitable mid cut alkyl (meth)acrylates include, but are not limited to: 2-ethylhexyl acrylate ("EHA"), 2-ethylhexyl methacrylate, octyl methacrylate, decyl methacrylate, isodecyl methacrylate ("IDMA", based on branched (C₁₀)alkyl isomer mixture), undecyl methacrylate, dodecyl methacrylate (also known as lauryl methacrylate), tridecyl methacrylate, tetradecyl methacrylate (also known as myristyl methacrylate), pentadecyl methacrylate and mixtures thereof. Particularly useful mixtures include dodecyl-pentadecyl methacrylate ("DPMA"), a mixture of linear and branched isomers of dodecyl, tridecyl, tetradecyl and pentadecyl methacrylates; and lauryl-myristyl methacrylate ("LMA").

"High cut" alkyl (meth)acrylates are typically those where the alkyl group contains from 16 to 24 carbon atoms. Suitable high cut alkyl (meth)acrylates include, but are not limited to: hexadecyl methacrylate, heptadecyl methacrylate, octadecyl methacrylate, nonadecyl methacrylate, cosyl methacrylate, eicosyl methacrylate and mixtures thereof. Particularly useful mixtures of high cut alkyl (meth)acrylates include, but are not limited to: cetyl-eicosyl methacrylate ("CEMA"), which is a mixture of hexadecyl, octadecyl, cosyl and eicosyl methacrylate; and cetyl-stearyl methacrylate ("SMA"), which is a mixture of hexadecyl and octadecyl methacrylate.

The mid-cut and high-cut alkyl (meth)acrylate monomers described above are generally prepared by standard esterification procedures using technical grades of long chain aliphatic alcohols, and these commercially available alcohols are mixtures of alcohols of varying chain lengths containing between 10 and 15 or 16 and 20 carbon atoms in the alkyl group. Examples of these alcohols are the various Ziegler catalyzed ALFOL alcohols from Vista Chemical company, i.e., ALFOL 1618 and ALFOL 1620, Ziegler catalyzed various NEODOL alcohols from Shell Chemical Company, i.e. NEODOL 25L, and naturally derived alcohols such as Proctor & Gamble's TA-1618 and CO-1270. Consequently, for the purposes of this invention, alkyl (meth)acrylate is intended to include not only the individual alkyl (meth)acrylate product named, but also to include mixtures of the alkyl (meth)acrylates with a predominant amount of the particular alkyl (meth)acrylate named.

The alkyl (meth)acrylate monomers useful in the present invention may be a single monomer or a mixture having different numbers of carbon atoms in the alkyl portion. Also, the (meth)acrylamide and alkyl (meth)acrylate monomers useful in the present invention may optionally be substituted. Suitable optionally substituted (meth)acrylamide and alkyl (meth)acrylate monomers include, but are not limited to: hydroxy (C₂-C₆)alkyl (meth)acrylates, dialkylamino(C₂-C₆)-alkyl (meth)acrylates, dialkylamino(C₂-C₆)alkyl (meth)acrylamides.

Particularly useful substituted alkyl (meth)acrylate monomers are those with one or more hydroxyl groups in the alkyl radical, especially those where the hydroxyl group is found at the β-position (2-position) in the alkyl radical. Hydroxyalkyl (meth)acrylate monomers in which the substituted alkyl group is a (C₂-C₆)alkyl, branched or unbranched, are preferred. Suitable hydroxyalkyl (meth)acrylate monomers include, but are not limited to: 2-hydroxyethyl methacrylate ("HEMA"), 2-hydroxyethyl acrylate ("HEA"), 2-hydroxypropyl methacrylate, 1-methyl-2-hydroxyethyl methacrylate, 2-hydroxy-propyl acrylate, 1-methyl-2-hydroxyethyl acrylate, 2-hydroxybutyl methacrylate, 2-hydroxybutyl acrylate and mixtures thereof. The preferred hydroxyalkyl (meth)acrylate monomers are HEMA, 1-methyl-2-hydroxyethyl methacrylate, 2-hydroxypropyl methacrylate and mixtures thereof. A mixture of the latter two monomers is commonly referred to as "hydroxypropyl methacrylate" or HPMA.

Other substituted (meth)acrylate and (meth)acrylamide monomers useful in the present invention are those with a dialkylamino group or dialkylaminoalkyl group in the alkyl radical. Examples of such substituted (meth)acrylates and (meth)acrylamides include, but are not limited to: dimethylaminoethyl methacrylate, dimethylaminoethyl acrylate, N,N-dimethylaminoethyl methacrylamide, N,N-dimethyl-aminopropyl methacrylamide, N,N-dimethylaminobutyl methacrylamide, N,N-di-ethylaminoethyl methacrylamide, N,N-diethylaminopropyl methacrylamide, N,N-diethylaminobutyl methacrylamide, N-(1,1-dimethyl-3-oxobutyl) acrylamide, N-(1,3-diphenyl-1-ethyl-3-oxobutyl) acrylamide, N-(1-methyl-1-phenyl-3-oxobutyl) methacrylamide, and 2-hydroxyethyl acrylamide, N-methacrylamide of aminoethyl ethylene urea, N-methacryloxy ethyl morpholine, N-maleimide of dimethylaminopropylamine and mixtures thereof.

Other substituted (meth)acrylate monomers useful in the present invention are silicon-containing monomers such as γ-propyl tri(C₁-C₆)alkoxysilyl (meth)acrylate, γ-propyl tri(C₁-C₆)alkylsilyl (meth)acrylate, γ-propyl di(C₁-C₆)alkoxy(C₁-C₆)alkylsilyl (meth)acrylate, γ-propyl di(C₁-C₆)alkyl(C₁-C₆)alkoxysilyl (meth)acrylate, vinyl tri(C₁-C₆)alkoxysilyl (meth)acrylate, vinyl di(C₁-C₆)alkoxy(C₁-C₆)alkylsilyl (meth)acrylate, vinyl (C₁-C₆)alkoxydi(C₁-C₆)alkylsilyl (meth)acrylate, vinyl tri(C₁-C₆)alkylsilyl (meth)acrylate, and mixtures thereof.

The vinyl aromatic monomers useful as unsaturated monomers in the present invention include, but are not limited to: styrene ("STY"), α-methylstyrene, vinyltoluene, *p*-methylstyrene, ethylvinylbenzene, vinylnaphthalene, vinylxylenes, and mixtures thereof. The vinylaromatic monomers also include their corresponding substituted counterparts, such as halogenated derivatives, i.e., containing one or more halogen groups, such as fluorine, chlorine or bromine; and nitro, cyano, (C₁-C₁₀)alkoxy, halo(C₁-C₁₀)alkyl, carb(C₁-C₁₀)alkoxy, carboxy, amino, (C₁-C₁₀)alkylamino derivatives and the like.

The nitrogen-containing compounds and their thio-analogs useful as unsaturated monomers in the present invention include, but are not limited to: vinylpyridines such as 2-vinylpyridine or 4-vinylpyridine; lower alkyl (C₁-C₈) substituted N-vinyl pyridines such as 2-methyl-5-vinyl-pyridine, 2-ethyl-5-vinylpyridine, 3-methyl-5-vinylpyridine, 2,3-dimethyl-5-vinyl-pyridine, and 2-methyl-3-ethyl-5-vinylpyridine; methyl-substituted quinolines and isoquinolines; N-vinylcaprolactam; N-vinylbutyrolactam; N-vinylpyrrolidone; vinyl imidazole; N-vinyl carbazole; N-vinyl-succinimide; (meth)acrylonitrile; *o*-, *m*-, or *p*-aminostyrene; maleimide; N-vinyl-oxazolidone; N,N-dimethyl aminoethyl-vinyl-ether; ethyl-2-cyano acrylate; vinyl acetonitrile; N-vinylphthalimide; N-vinyl-pyrrolidones such as N-vinyl-thio-pyrrolidone, 3 methyl- 1-vinyl-pyrrolidone, 4-methyl-1-vinyl-pyrrolidone, 5-methyl-1-vinyl-pyrrolidone, 3-ethyl-1-vinyl-pyrrolidone, 3-butyl-1-vinyl-pyrrolidone, 3,3-dimethyl-1-vinyl-pyrrolidone, 4,5-dimethyl-1-vinyl-pyrrolidone, 5,5-dimethyl-1-vinyl-pyrrolidone, 3,3,5-trimethyl-1-vinylpyrrolidone, 4-ethyl-1-vinyl-pyrrolidone, 5-methyl-5-ethyl-1-vinyl-pyrrolidone and 3,4,5-trimethyl-1-vinyl-pyrrolidone; vinyl pyrroles; vinyl anilines; and vinyl piperidines.

The substituted ethylene monomers useful as unsaturated monomers is in the present invention include, but are not limited to: vinyl acetate, vinyl formamide, vinyl chloride, vinyl fluoride, vinyl bromide, vinylidene chloride, vinylidene fluoride and vinylidene bromide.

Suitable unsubstituted cyclic olefin monomers useful as comonomers in the present invention are (C₅-C₁₀)cyclic olefins, such as cyclopentene, cyclopentadiene, dicylopentene, cyclohexene, cyclohexadiene, cycloheptene, cycloheptadiene, cyclooctene, cyclooctadiene, norbornene and the like. Suitable substituted cyclic olefin monomers include, but are not limited to, cyclic olefins having one or more substituent groups selected from hydroxy, aryloxy, halo, (C₁-C₁₂)alkyl, (C₁-C₁₂)haloalkyl, (C₁-C₁₂)hydroxyalkyl, (C₁-C₁₂)halohydroxyalkyl such as (CH₂)ₙ,C(CF₃)₂OH where n' = 0 to 4, (C₁-C₁₂)alkoxy, thio, amino, (C₁-C₆)alkylamino, (C₁-C₆)dialkylamino, (C₁-C₁₂)alkylthio, carbo(C₁-C₂₀)alkoxy, carbo(C₁-C₂₀)haloalkoxy, (C₁-C₁₂)acyl, (C₁-C₆)alkylcarbonyl(C₁-C₆)alkyl, and the like. Particularly suitable substituted cyclic olefins include cyclic olefins containing one or more of hydroxy, aryloxy, (C₁-C₁₂)alkyl, (C₁-C₁₂)haloalkyl, (C₁-C₁₂)hydroxyalkyl, (C₁-C₁₂)halohydroxyalkyl, carbo(C₁-C₂₀)alkoxy, and carbo(C₁-C₂₀)haloalkoxy. It will be appreciated by those skilled in the art that the alkyl and alkoxy substituents may be optionally substituted, such as with halogen, hydroxyl, cyano, (C₁-C₆)alkoxyl, mercapto, (C₁-C₆)alkylthio, amino, acid labile leaving group and the like.

Suitable carbo(C₁-C₂₀)alkoxy substituents include, but are not limited to, those of the formula C(O)O-LG, wherein LG is a leaving group having 4 or more carbon atoms with at least one quaternary carbon atom bonded directly to the carboxyl group. Suitable leaving groups include, but are not limited to, tert-butyl, 2,3-dimethylbutyl, 2,3,4-trimethylpentyl and alicyclic leaving groups. Suitable alicyclic leaving groups include adamantyl, methyladamantyl, ethyladamantyl, methylnorbornyl, ethylnorbornyl, ethyltrimethylnorbornyl, and the like. Particularly useful alicyclic leaving groups are those of Formulae IIIa - IIId.

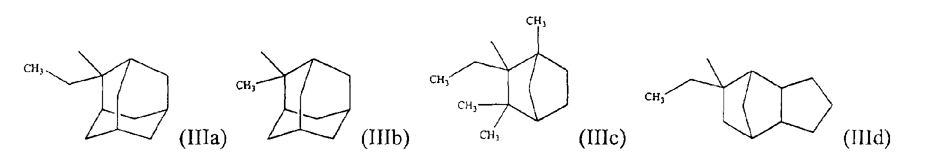

Other particularly useful cyclic olefin monomer substituents include, but are not limited to, Ar-O-LG and (CH₂)_{n'}C(CF₃)₂O-LG where n' = 0 to 4, wherein LG is as described above. It is preferred that the aryl group is phenyl.

Suitable ethylenically unsaturated cyclic olefins having one or more hydroxy groups include, but are not limited to, norbornenyl alcohols of Formula (IV) 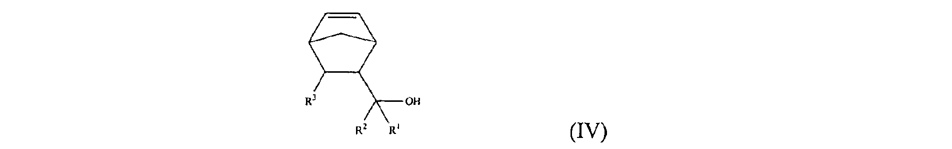 wherein R¹, R² and R³ are independently hydrogen and (C₁-C₈)alkyl and wherein R¹ and R³ may be joined to form a 5- to 7-member fused ring. It is preferred that R¹ and R³ are independently selected from hydrogen or (C₁-C₈)alkyl, R² = cyclohexyl or cyclopentyl, and R² and R³ may be joined to form a 5- to 7-member fused ring. It is further preferred that R¹ is hydrogen or methyl. Particularly useful norbornenyl alcohols are those of the Formulae IVa - IVc.

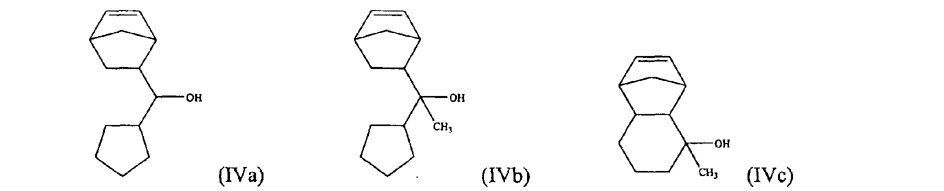

The cyclic polymers of the present invention may be prepared by a variety of methods, such as free-radical polymerization and metal catalyzed polymerization. Any catalyst is suitable for use in the present invention as long as it catalyzes the polymerization of the double bond of the cyclic olefinic monomers having one or more pendant electron withdrawing groups without substantially opening the rings of the cyclic monomer. Metal catalyzed polymerizations are preferred. Suitable free-radical polymerization catalysts include, but are not limited to: hydrogen peroxide, tert-butyl hydroperoxide, sodium persulfate, potassium persulfate, lithium persulfate; and the like. Such free-radical polymerization conditions will be clear to those skilled in the art.

It will be appreciated by those skilled in the art that more than one metal catalyst may be used in the polymerizations of the present invention. Suitable metal polymerization catalysts include, but are not limited to, palladium(II) catalysts, such as palladium dihalide, nonionic palladium(II)-halide complexes, (Pd(RCN)₄)(BF₄)₂, where R is (C₁-C₄)alkyl, palladium(II)-alkyl complexes, and (η³-allyl)palladium(II) compounds with weakly coordinating counterions. Preferred palladium(II) catalysts are (Pd(RCN)₄)(BF₄)₂, where R is (C₁-C₄)alkyl, (η³-allyl)palladium(II) compounds with weakly coordinating counterions, and mixtures thereof. Particularly useful palladium(II) catalysts include, but are not limited to: (Pd(CH₃CN)₄)(BF₄)₂ (Pd(C₂H₅CN)₄)(BF₄)₂, (η³-allyl)Pd(BF₄), ((η³-allyl)PdCl)₂, (η³-allyl)Pd(SbF₆), and mixtures of (η³-allyl)Pd(BF₄) and (η³-allyl)Pd(SbF₆). Such catalysts are generally known, see, for example, Mathew et al., *(η*^{*3*}*-Allyl)palladium(II) and Palladium(II) Nitrile Catalysts for the Addition Polymerization of Norbornene Derivatives with Functional Groups,* Macromolecules, vol. 29, pages 2755-2763, 1996, herein incorporated by reference to the extent it teaches the preparation and use of such catalysts.

Other suitable metal polymerization catalysts include nickel(II) catalysts having as ligands at least one of salicylaldimine or substituted salicylaldimine and at least one of acetonitrile or a phosphine, such as triphenylphosphine. Suitable substituted salicylaldimine ligands include those substituted in the ortho position to the oxygen with a bulky group, such as phenyl, substituted phenyl, anthracene, substituted anthracene, triphenylmethyl, meta-terphenyl and the like. Suitable catalysts are those disclosed in Younkin et al., *Neutral, Single-Component Nickel (II) Polyolefin Catalysts that Tolerate Heteroatoms,* Science, vol. 287, pp 460-462, January 21, 2000.

The ratio of monomer to metal catalyst in the polymerization reaction of the present invention can range from about 5000:1 to about 25:1, preferably from 1000:1 to 50:1, and more preferably from 100:1 to 50:1. The polymerization reaction using this catalyst can be run in a hydrocarbon solvent, such as cyclohexane, toluene, benzene, nitrobenzene, chlorobenzene, nitromethane, dichloromethane and mixtures thereof. A particularly useful solvent mixture is nitrobenzene and dichlorobenzene in a 4:1 ratio. The polymerization reactions using palladium(II) catalysts can be carried out at a temperature in the range of from about 0° to about 70° C. It is preferred that the polymerization reaction is carried out at a temperature of 10° to 50° C, and more preferably 20° to 40° C. The yields for the polymerizations are typically in the range of 25 to 100%.

The cyclic olefin polymers of the present invention may be used in any application where cyclic olefin polymers may be useful. Cyclic olefin polymers of the present invention containing as polymerized units one or more cyclic olefin monomers containing one or more pendant cyclic electron withdrawing groups are useful in electronics applications, such as, but not limited to, photoresist compositions, antireflective coating compositions, soldermasks, dielectrics, and the like. The cyclic olefin polymers of the present invention are particularly suitable for use as resin binders in photoresist compositions. When used in photoresist compositions, such cyclic olefin polymers of the present invention show reduced swelling and improved adhesion over known photoresist compositions.

Particularly suitable polymers of the present invention are those containing as polymerized units one or more cyclic olefin monomers having one or more pendant cyclic electron withdrawing groups and substituted cyclic olefin monomers, optionally including one or more ethylenically or acetylenically unsaturated monomers. Examples of such particularly useful polymers of the present invention include those of Formula V 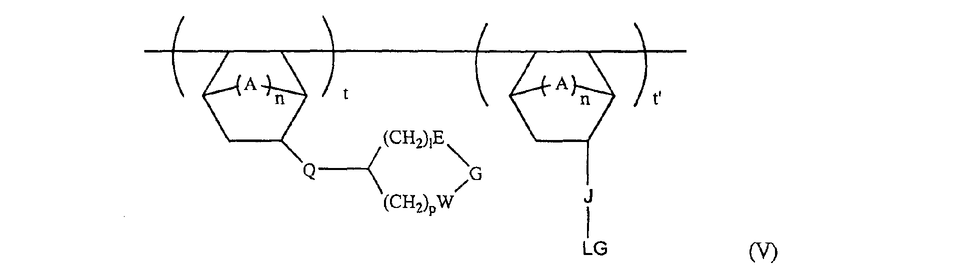 wherein A, Q, E, W, G, LG, 1, n and p are as described above, J = C(O)O-, Ar-O- and (CH₂)ₙ,C(CF₃)₂-O-; t is from 1 to 99 mole percent; and t' is 99 to 1 mole percent. It is preferred that t is from 5 to 90 mole percent and t' is from 90 to 10 mole percent. It will be appreciated by those skilled in the art that when t + t' < 100 %, other ethylenically or acetylenically unsaturated monomers will be present in the polymer as polymerized units. Other particularly useful polymers of the present invention are those of Formula VI 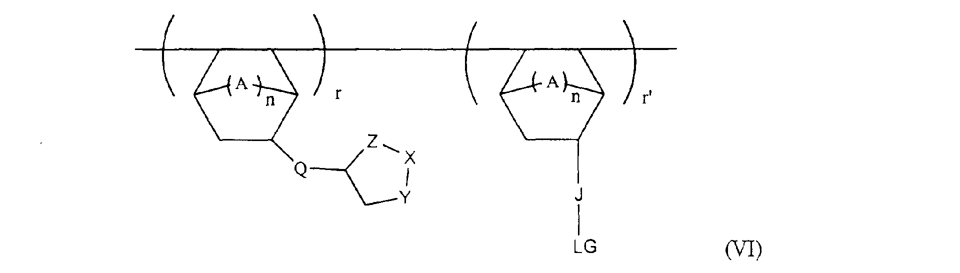 wherein A, Q, Z, X, Y, LG, J and n are as described above; r is from 1 to 99 mole percent; and r' is from 99 to 1 mole percent. It is preferred that r is from 5 to 90 mole percent and r' is from 90 to 10 mole percent. It will be appreciated by those skilled in the art that when r + r' < 100 %, other ethylenically or acetylenically unsaturated monomers will be present in the polymer as polymerized units. Still other particularly suitable polymers of the present invention are those that are free of maleic anhydride as polymerized units.

The photoresist compositions of the present invention include one or more photoactive components, one or more cyclic olefin resin binders of the present invention, and optionally one or more additives. The photoactive components useful in the present invention are typically photoacid or photobase generators, and preferably photoacid generators.

The photoacid generators useful in the present invention are any compounds which liberate acid upon exposure to light, typically at a wavelength of about 320 to 420 nanometers, however other wavelengths may be suitable. Suitable photoacid generators include halogenated triazines, onium salts, sulfonated esters and halogenated sulfonyloxy dicarboximides.

Particularly useful halogenated triazines include halomethyl-s-triazines. Suitable halogenated triazines include for example, 2-[1-(3,4-benzodioxolyl)]-4,6-bis(trichloromethyl)-1,2,5-triazine, 2-[1-(2,3-benzodioxolyl)]-4,6-bis(trichloromethyl)-1,3,5-triazine, 2-[1-(3,4-benzodioxolyl)]-4,6-bis(tribromomethyl)-1,3,5-triazine, 2-[1-(2,3-benzodioxolyl)]-4,6-bis(tribromomethyl)-1,3,5-triazine, 2-(2-furfylethylidene)-4,6-bis(trichloromethyl)-1,3,5-triazine, 2-[2-(5-methylfuryl)ethylidene]-4,6-bis(trichloromethyl)-1,3,5-triazine, 2-[2-(4-methylfuryl)ethylidene]-4,6-bis(trichloromethyl)-1,3,5-triazine, 2-[2-(3-methylfuryl)ethylidene]-4,6-bis-(trichloromethyl)-1,3,5-triazine, 2-[2-(4,5-dimethylfuryl)ethylidene]-4,6-bis(trichloromethyl)-1,3,5-triazine, 2-[2-(5-methoxyfuryl)ethylidene]-4,6-bis(trichloromethyl)-1,3,5-triazine, 2-[2-(4-methoxyfuryl)ethylidene]-4,6-bis(trichloromethyl)-1,3,5-triazine, 2-[2-(3-methoxyfuryl)ethylidene]-4,6-bis (trichloromethyl)-1,3,5-triazine, 2-[2-(4,5-dimethoxy-furyl)ethylidene]-4,6-bis(trichloromethyl)-1,3,5-triazine, 2-(2-furfylethylidene)-4,6-bis(tribromomethyl)-1,3,5-triazine, 2-[2-(5-methylfuryl)ethylidene]-4,6-bis(tribromomethyl)-1,3,5-triazine, 2-[2-(4-methylfuryl)-ethylidene]-4,6-bis(tribromomethyl)-1,3,5-triazine, 2-[2-(3-methylfuryl)ethylidene]-4,6-bis(tribromomethyl)-1,3,5-triazine, 2-[2-(4,5-dimethoxyfuryl)ethylidene]-4,6-bis(tribromomethyl)-1,3,5-triazine, 2-[2-(5-methoxyfuryl)ethylidene]-4,6-bis(tribromomethyl)-1,3,5-triazine, 2-[2-(4-methoxyfuryl)ethylidene]-4,6-bis (tribromomethyl)-1,3,5-triazine, 2-[2-(3-methoxyfuryl)ethylidene]-4,6-bis(tribromomethyl)-1,3,5-triazine, 2-[2-(4,5-dimethoxyfuryl)ethylidene]-4,6-bis(tribromomethyl)-1,3,5-triazine, 2,4,6-tris-(trichloromethyl)-1,3,5-triazine, 2,4,6-tris-(tribromomethyl)-1,3,5-triazine, 2-phenyl-4,6-bis(trichloromethyl)-1,3,5-triazine, 2-phenyl-4,6-bis(tribromomethyl)-1,3,5-triazine, 2-(4-methoxyphenyl)-4,6-bis(trichloromethyl)-1,3,5-triazine, 2-(4-methoxyphenyl)-4,6-bis(tribromomethyl)-1,3,5-triazine, 2-(1-naphthyl)-4,6-bis(trichloromethyl)-1,3,5-triazine, 2-(1-naphthyl)-4,6-bis(tribromomethyl)-1,3,5-triazine, 2-(4-methoxy-1-naphthyl)-4,6-bis(trichloromethyl)-1,3,5-triazine, 2-(4-methoxy-1-naphthyl)-4,6-bis(tribromomethyl)-1,3,5-triazine, 2-(4-chlorophenyl)-4,6-bis(tribromomethyl)-1,3,5-triazine, 2-styryl-4,6-bis(trichloromethyl)-1,3,5-triazine, 2-styryl-4,6-bis(tribromomethyl)-1,3,5-triazine, 2-(4-methoxystyryl)-4,6-bis(trichloromethyl)-1,3,5-triazine, 2-(4-methoxystyryl)-4,6-bis(tribromomethyl)-1,3,5-triazine, 2-(3,4,5-trimethoxystyryl)-4,6-bis(trichloromethyl)-1,3,5-triazine, 2-(3,4,5-trimethoxystyryl)-4,6-bis(tribromomethyl)-1,3,5-triazine, 2-(3-chloro-1-phenyl)-4,6-bis(trichloromethyl)-1,3,5-triazine, 2-(3-chlorophenyl)-4,6-bis(tribromomethyl)-1,3,5-triazine and the like. Other triazine type photoacid generators useful in the present invention are disclosed in US Patent. No. 5,366,846, herein incorporated by reference.

The s-triazine compounds are condensation reaction products of certain methyl-halomethyl-s-triazines and certain aldehydes or aldehyde derivatives. Such s-triazine compounds may be prepared according to the procedures disclosed in U.S. Pat. No. 3,954,475 and Wakabayashi et al., Bulletin of the Chemical Society of Japan, 42, 2924-30 (1969).

Onium salts with weakly nucleophilic anions are particularly suitable for use as photoacid generators in the present invention. Examples of such anions are the halogen complex anions of divalent to heptavalent metals or non-metals, for example, antimony, tin, iron, bismuth, aluminum, gallium, indium, titanium, zirconium, scandium, chromium, hafnium, copper, boron, phosphorus and arsenic. Examples of suitable onium salts include, but are not limited to: diaryldiazonium salts and onium salts of group VA and B, IIA and B and I of the Periodic Table, for example, halonium salts, quaternary ammonium, phosphonium and arsonium salts, aromatic sulfonium salts and sulfoxonium salts or selenium salts. Examples of suitable onium are disclosed in US Patent Nos. 4,442,197; 4,603,101; and 4,624,912, all incorporated herein by reference.

The sulfonated esters useful as photoacid generators in the present invention include sulfonyloxy ketones. Suitable sulfonated esters include, but are not limited to: benzoin tosylate, t-butylphenyl alpha-(p-toluenesulfonyloxy)-acetate, and t-butyl alpha-(p-toluenesulfonyloxy)-acetate. Such sulfonated esters are disclosed in the Journal of Photopolymer Science and Technology, vol. 4, No. 3,337-340 (1991), incorporated herein by reference.

Suitable halogenated sulfonyloxy dicarboximides useful as photoacid generators in the present invention include, but are not limited to: 1(((trifluoromethyl)sulfonyl)oxy)-1H-pyrrole-2,5-dione; N-((perfluorooctanesulfonyl)oxy)-5-norbornene-2,3-dicarboximide; 1-(((trifluoromethyl)sulfonyl)oxy)-2,5-pyrrolidinedione; 3a,4,7,7a-tetrahydro-2-(((trifluoromethyl)sulfonyl)oxy)-4,7-methano-1H-isoindole-1,3(2H)-dione; 2-(((trifluoromethyl)sulfonyl)oxy)- 1H-benz(f)isoindole-1,3(2H)-dione; 3,4-dimethyl-1-(((trifluoromethyl)sulfonyl)oxy)- 1H-pyrrole-2,5-dione; 2-(((trifluoromethyl)sulfonyl)oxy)- 1H-isoindole-1,3(2H)-dione; 2-(((trifluoromethyl)sulfonyl)oxy)- 1H-benz(de)isoquinoline-1,3(2H)-dione; 4,5,6,7-tetrahydro-2-(((trifluoromethyl)sulfonyl)oxy)- 1H-isoindole-1,3(2H)-dione; 3a,4,7,7a-tetrahydro-2-(((trifluoromethyl)sulfonyl)oxy)-4,7-epoxy- 1H-isoindole-1,3(2H)-dione; 2,6-bis-(((trifluoromethyl)sulfonyl)oxy)-benzo(1,2-c:4,5-c')dipyrrole-1,3,5,7(2H,6H)-tetrone; hexahydro-2,6-bis-(((trifluoromethyl)sulfonyl)oxy)-4,9-methano-1H-pyrrolo(4,4-g)isoquinoline-1,3,5,7(2H,3aH,6H)-tetrone; 1,8,8-trimethyl-3-(((trifluoromethyl)sulfonyl)oxy)-3-azabicyclo(3.2.1)octane-2,4-dione; 4,7-dihydro-2--(((trifluoromethyl)sulfonyl)oxy)-4,7-epoxy-1H-isoindole-1,3(2H)-dione; 3-(1-naphthalenyl)-4-phenyl-1--(((trifluoromethyl)sulfonyl)oxy)-1H-pyrrole-2,5-dione; 3,4-diphenyl-1--(((trifluoromethyl)sulfonyl)oxy)-1H-pyrrole-2,5-dione; 5,5'-(2,2,2-trifluoro-1-(triflluoromethyl)ethylidene)bis(2-(((trifluoromethyl)sulfonyl)oxy)-1H-isoindole-1,3(2H)-dione; tetrahydro-4-(((trifluoromethyl)sulfonyl)oxy)-2,6-methano-2H-oxireno(f)isoindole-3,5(1aH,4H)-dione; 5,5'-oxybis-2-(((trifluoromethyl)sulfonyl)oxy)-1H-isoindole-1,3(2H)-dione; 4-methyl-2-(((trifluoromethyl)sulfonyl)oxy)-1H-isoindole-1,3(2H)-dione; 3,3,4,4-tetramethyl-1-(((trifluoromethyl)sulfonyl)oxy)-2,5-pyrrolidinedione and mixtures thereof. It is preferred that the halogenated sulfonyloxy dicarboximides comprise one or more of I (((trifluoromethyl)sulfonyl)oxy)-1H-pyrrole-2,5-dione; N-((perfluorooctanesulfonyl)oxy)-5-norbornene-2,3-dicarboximide; and 1-(((trifluoromethyl)sulfonyl)oxy)-2,5-pyrrolidinedione, and more preferably N-((perfluorooctanesulfonyl)oxy)-5-norbornene-2,3-dicarboximide.

The photoactive components are typically added to photoresist compositions in an amount sufficient to generate a latent image in a coating layer of resist material upon exposure to activating radiation. When the photoactive component is a photoacid generator, the amount is typically in the range of 0.1 to 10 percent by weight, based on the weight of the resin, and preferably 1 to 8 percent by weight. It will be appreciated by those skilled in that art that more than one photoacid generators may be used advantageously in the photoresist compositions of the present invention.

Any cyclic olefin polymers of the present invention may be advantageously used as the resin binders in the photoresist compositions of the present invention. It will appreciated by those skilled in the art that more than one resin binder may be used in the photoresist compositions of the present invention, including more than one cyclic olefin resin binder. Thus, the cyclic olefin resin binders of the present invention may be advantageously combined with one or more other resin binders.

The optional additives that may be used in the photoresist compositions of the present invention include, but are not limited to: anti-striation agents, plasticizers, speed enhancers, fillers, dyes and the like. Such optional additives will be present in relatively minor concentrations in a photoresist composition except for fillers and dyes which may be used in relatively large concentrations, e.g. in amounts of from about 5 to 30 percent by weight, based on the total weight of the composition's dry components.

The photoresist compositions of the present invention may be readily prepared by those skilled in the art. For example, a photoresist composition of the invention can be prepared by dissolving the components of the photoresist in a suitable solvent. Such suitable solvents include, but are not limited to: ethyl lactate, ethylene glycol monomethyl ether, ethylene glycol monomethyl ether acetate, propylene glycol monomethyl ether, propylene glycol monomethyl ether acetate, 3-ethoxyethyl propionate, 2-heptanone, γ-butyrolactone, and mixtures thereof.

Typically, the solids content of the photoresist composition varies from about 5 to about 35 percent by weight, based on the total weight of the composition. The resin binder and photoacid generators should be present in amounts sufficient to provide a film coating layer and formation of good quality latent and relief images.

Such photoresist compositions may be applied to a substrate by any known means, such as spinning, dipping, roller coating and the like. When the compositions are applied by spin coating, the solids content of the coating solution can be adjusted to provide a desired film thickness based upon the specific spinning equipment utilized, the viscosity of the solution, the speed of the spinner and the amount of time allowed for spinning.

Photoresist compositions including the cyclic olefin polymers of the present invention are useful in all applications where photoresists are typically used. For example, the compositions may be applied over silicon wafers or silicon wafers coated with silicon dioxide for the production of microprocessors and other integrated circuit components. Aluminum-aluminum oxide, gallium arsenide, ceramic, quartz, copper, glass and the like are also suitable employed as substrates for the photoresist compsitions of the invention.

Once the photoresist composition is coated on a substrate surface, it is dried by heating to remove any solvent. It is preferably dried until the coating is tack free. Thereafter, it is imaged through a mask in a conventional manner. The exposure is sufficient to effectively activate the photoacid component of the photoresist to produce a patterned image in the resist coating layer, and more specifically, the exposure energy typically ranges from about 1 to 100 mJ/cm², dependent upon the exposure tool and the components of the photoresist composition.

The photoresist compositions of the present invention are preferably activated by a short exposure wavelength, particularly a sub-300 nm, such as UV, and more preferably a sub-200 nm exposure wavelength. Particularly preferred wavelengths include 248, 193, 157 nm and 11-15 nm. However, the photoresist compositions of the present invention may be used with other radiation sources, such as, but not limited to, visible, e-beam, ion-beam and x-ray.

Following exposure, the film layer of the composition is preferably baked at temperatures ranging from about 70° C to 160° C. Thereafter, the film is developed. The exposed resist film is rendered positive working by employing a polar developer, preferably an aqueous based developer, such as quarternary ammonium hydroxide solutions, such as tetra-alkyl ammonium hydroxide, preferably a 0.26 N tetramethylammonium hydroxide; various amine solutions, such as ethylamine, n-propylamine, diethylamine, triethylamine or methyl diethylamine; alcohol amines, such as diethanolamine, triethanolamine; cyclic amines, such as pyrrole, pyridine, and the like. One skilled in the art will appreciate which development procedures should be used for a given system.

After development of the photoresist coating, the developed substrate may be selectively processed on those areas bared of resist, for example, by chemically etching or plating substrate areas bared of resist in accordance with procedures known in the art. For the manufacture of microelectronic substrates, e.g. the manufacture of silicon dioxide wafers, suitable etchants include, but are not limited to, a gas etchant, such as a chlorine- or fluorine-based etchant, such as Cl₂ or CF₄/CHF₃ etchant applied as a plasma stream. After such processing, the resist may be removed from the processed substrate using any stripping procedures known in the art.

## Claims

1. A polymer including as polymerized units one or more cyclic olefin monomers of the formula 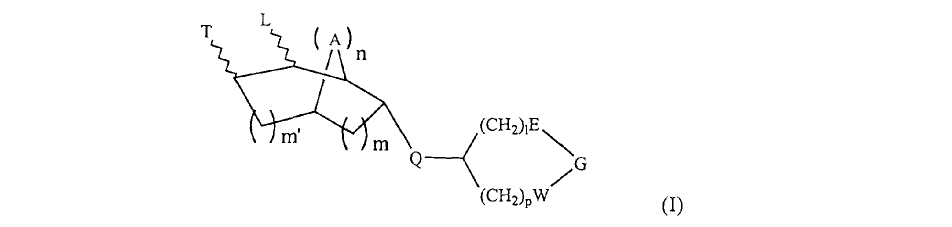 wherein A = O, S, CH₂, and NR¹; R¹ = phenyl, substituted phenyl, benzyl, substituted benzyl, (C₁-C₈)alkyl and substituted (C₁-C₈)alkyl; G = C(Z'), O, S, and NR²; R² = (C₁-C₈)alkyl and substituted (C₁-C₈)alkyl; E and W are independently selected from C(Z'), O, NR² and a chemical bond; Z' = O or S; Q is a chemical bond or a linking group; n = 0 to 3; m = 0 to 2; m' = 0 to 2; 1 = 0 to 5; and p = 0 to 5; provided that 1 + p = 3 to 5; provided that when A = O, S or NR¹, n = 1; wherein T and L are taken together and selected from a double bond or a 5 to 8-membered unsaturated ring; and optionally one or more ethylenically or acetylenically unsaturated monomers.

2. The polymer of claim 1 wherein Q is a linking group having from 1 to 12 carbon atoms wherein one or more of the carbon atoms may be independently replaced by a functional group selected from ester, thioester, ether, ketone, sulfate, sulfonamide, amide, amine, sulfone, glycol ether or silyl.

3. The polymer of claim 1 wherein the cyclic monomer has the formula 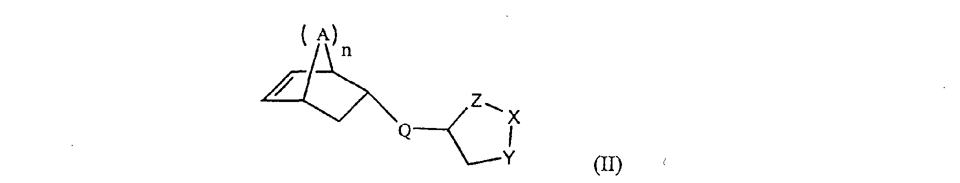 wherein A = O, S, CH₂, and NR¹; R¹ = phenyl, substituted phenyl, benzyl, substituted benzyl, (C₁-C₈)alkyl and substituted (C₁-C₈)alkyl; Q is a chemical bond or a linking group, Z = CR⁷R⁸, C(O), C(S), O or S; X and Y are independently selected from CH₂, C(O), C(S), O or NR²; and R² = (C₁-C₈)alkyl and substituted (C₁-C₈)alkyl; R⁷ and R⁸ are independently selected from H, (C₁-C₆)alkyl, and substuituted (C₁-C₆)alkyl; n = 0 to 3; provided that at least one of X, Y and Z is selected from C(O) or C(S); and wherein the cyclic olefin monomer is optionally substituted.

4. The polymer of claim 1 having the formula 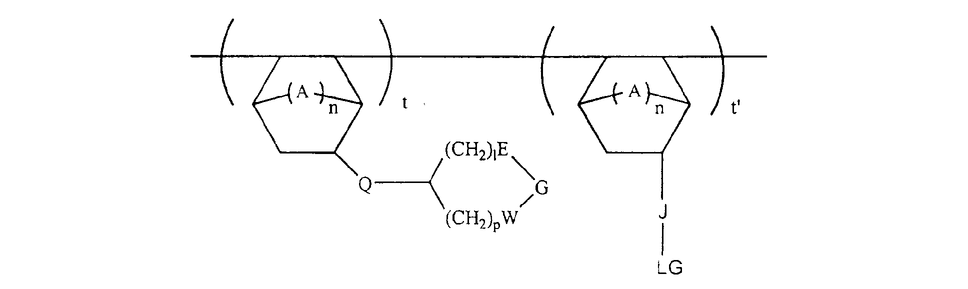 wherein A = O, S, CH₂, and NR¹; R¹ = phenyl, substituted phenyl, benzyl, substituted benzyl, (C₁-C₈)alkyl and substituted (C₁-C₈)alkyl; G = C(Z'), O, S, and NR²; R² = (C₁-C₈)alkyl and substituted (C₁-C₈)alkyl; E and W are independently selected from C(Z'), O, NR² and a chemical bond; Z' = O or S; Q is a chemical bond or a linking group; n = 0 to 3; 1 = 0 to 5; and p = 0 to 5; provided that 1 + p = 3 to 5; J = C(O)O-, Ar-O- and (CH₂)ₙ,C(CF₃)₂-O-; LG is a leaving group having 4 or more carbon atoms with at least one quaternary carbon atom bonded directly to the carboxyl group; t is from 1 to 99 mole percent; and t' is from 99 to 1 mole percent.

5. The polymer of claim 4 wherein Q is is a linking group having from 1 to 12 carbon atoms wherein one or more of the carbon atoms may be independently replaced by a functional group selected from ester, thioester, ether, ketone, sulfate, sulfonamide, amide, amine or sulfone.

6. The polymer of claim 4 wherein LG is selected from tert-butyl, 2,3-dimethylbutyl, 2,3,4-trimethylpentyl and alicyclic leaving groups.

7. The polymer of claim 1 having the formula 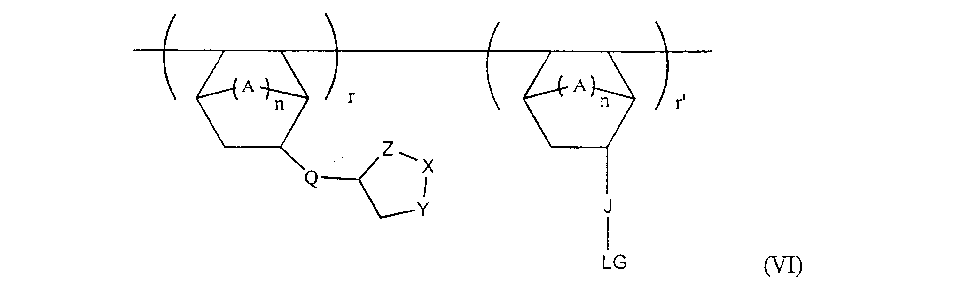 wherein A = O, S, CH₂, and NR¹; R¹ = phenyl, substituted phenyl, benzyl, substituted benzyl, (C₁-C₈)alkyl and substituted (C₁-C₈)alkyl; Q is a chemical bond or a linking group, Z = CR⁷R⁸, C(O), C(S), O or S; X and Y are independently selected from CH₂, C(O), C(S), O or NR²; and R² = (C₁-C₈)alkyl and substituted (C₁-C₈)alkyl; R⁷ and R⁸ are independently selected from H, (C₁-C₆)alkyl, and substuituted (C₁-C₆)alkyl; n = 0 to 3; provided that at least one of X, Y and Z is selected from C(O) or C(S); J = C(O)O-, Ar-O- and (CH₂)ₙ,C(CF₃)₂-O-; LG is a leaving group having 4 or more carbon atoms with at least one quaternary carbon atom bonded directly to the carboxyl group; r is from 1 to 99 mole percent; and r' is from 99 to 1 mole percent.

8. The polymer of claim 6 wherein Q is a linking group having from 1 to 12 carbon atoms wherein one or more of the carbon atoms may be independently replaced by a functional group selected from ester, thioester, ether, ketone, sulfate, sulfonamide, amide, amine, sulfone, glycol ether or silyl.

9. The polymer of claim 8 wherein LG is selected from tert-butyl, 2,3-dimethylbutyl, 2,3,4-trimethylpentyl and alicyclic leaving groups.

10. The polymer of claim 9 wherein the alicyclic leaving group is selected from

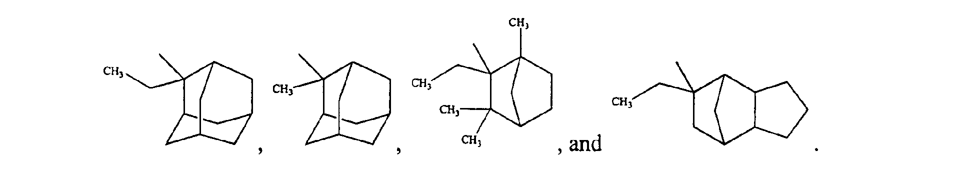

11. A method of polymerizing one or more cyclic olefin monomers of the formula 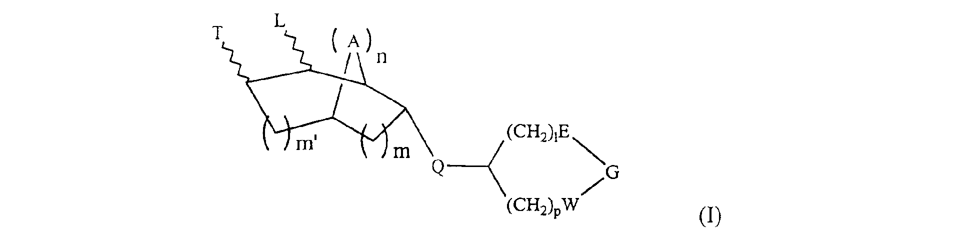 wherein A = O, S, CH₂, and NR¹; R¹ = phenyl, substituted phenyl, benzyl, substituted benzyl, (C₁-C₈)alkyl and substituted (C₁-C₈)alkyl; G = C(Z'), O, S, and NR²; R² = (C₁-C₈)alkyl and substituted (C₁-C₈)alkyl; E and W are independently selected from C(Z'), O, NR² and a chemical bond; Z' = O or S; Q is a chemical bond or a linking group; n = 0 to 3; m = 0 to 2; m' = 0 to 2; 1 = 0 to 5; and p = 0 to 5; provided that 1 + p = 3 to 5; provided that when A = O, S or NR¹, n = 1; wherein T and L are taken together and selected from a double bond or a 5 to 8-membered unsaturated ring; including the step of contacting the one or more cyclic olefin monomers with one or more catalysts selected from palladium(II) polymerization catalyst, nickel(II) polymerization catalyst and free radical polymerization catalyst.

12. The method of claim 11 wherein the palladium(II) catalyst comprises palladium dihalide, nonionic palladium(II)-halide complexes, (Pd(RCN)₄)(BF₄)₂, where R is (C₁-C₄)alkyl, palladium(II)-alkyl complexes, and (η³-allyl)palladium(II) compounds with weakly coordinating counterions.

13. The method of claim 11 wherein the palladium(II) catalyst comprises (Pd(RCN)₄)(BF₄)₂, where R is (C₁-C₄)alkyl, (η³-allyl)palladium(II) compounds with weakly coordinating counterions, and mixtures thereof.

14. The method of claim 11 wherein the free radical polymerization catalyst is selected from hydrogen peroxide, tert-butyl hydroperoxide, sodium persulfate, potassium persulfate or lithium persulfate.

15. The method of claim 11 wherein the nickel(II) polymerization catalyst is selected from nickel(II) catalysts having as ligands at least one of salicylaldimine or substituted salicylaldimine and at least one of acetonitrile or phosphine.

16. A photoresist composition including one or more polymers of claim 1 and a photoactive component.

17. The photoresist composition of claim 16 further comprising a solvent.

18. The photoresist composition of claim 17 wherein the solvent comprises ethyl lactate, ethylene glycol monomethyl ether, ethylene glycol monomethyl ether acetate, propylene glycol monomethyl ether, propylene glycol monomethyl ether acetate, 3-ethoxyethyl propionate, 2-heptanone, γ-butyrolactone, and mixtures thereof.

19. A method for forming a photoresist relief image, including the steps of applying a coating layer of the photoresist composition of claim 16; exposing the photoresist coating layer to patterned activating radiation; developing the exposed photoresist coating layer to provide a photoresist relief image.

20. A relief image formed by the method of claim 19.
